Europäisches Patentamt

European Patent Office

Office européen des brevets

(19)

(11) **EP 0 824 706 B1**

(12) **FASCICULE DE BREVET EUROPEEN**

(45) Date de publication et mention
de la délivrance du brevet:
**12.06.2002 Bulletin 2002/24**

(51) Int Cl.$^7$: **G01S 5/14**

(21) Numéro de dépôt: **97908333.4**

(22) Date de dépôt: **11.03.1997**

(86) Numéro de dépôt international:
**PCT/FR97/00424**

(87) Numéro de publication internationale:
**WO 97/34162 (18.09.1997 Gazette 1997/40)**

(54) **PROCEDE DE REDUCTION AUTONOME DES SEUILS D'ACQUISITION ET DE POURSUITE DES PORTEUSES RE UES EN ORBITE**

**VERFAHREN ZUR REDUZIERUNG DER SCHWELLENWERTE ZUR ERFASSUNG UND VERFOLGUNG VON IN DER UMLAUFBAHN EMPFANGENEN TRÄGERN**

**METHOD FOR AUTOMATICALLY REDUCING ORBIT-RECEIVED CARRIER ACQUISITION AND TRACKING THRESHOLDS**

(84) Etats contractants désignés:
**DE ES FR GB IT SE**

(30) Priorité: **12.03.1996 FR 9603079**

(43) Date de publication de la demande:
**25.02.1998 Bulletin 1998/09**

(73) Titulaire: **CENTRE NATIONAL D'ETUDES SPATIALES**
**75001 Paris (FR)**

(72) Inventeur: **ISSLER, Jean-Luc**
**F-31650 Saint-Orens (FR)**

(74) Mandataire: **Dubois-Chabert, Guy et al**
**BREVATOME**
**3, rue du Docteur Lanceraux**
**75008 Paris (FR)**

(56) Documents cités:
**EP-A- 0 274 958          EP-A- 0 544 358**
**WO-A-94/28434          DE-C- 3 808 328**

## Description

Domaine technique

L'invention concerne un procédé de réduction autonome des seuils d'acquisition et de poursuite des porteuses reçues en orbite.

Etat de la technique antérieure

L'invention combine trois éléments de base :

- un récepteur de signaux radioélectriques ;
- un filtre d'orbitographie embarqué ;
- une technique de réduction de seuil par aide précise en vitesse radiale.

On va considérer ci-dessous chacun de ces trois éléments.

- Le récepteur peut être n'importe quel équipement radioélectrique, à bord d'un satellite (références [1], [2], [5]). Les signaux reçus peuvent être émis par d'autres satellites en orbite ou depuis des points fixes au sol. A titre d'exemple, ces récepteurs peuvent être du type :

  - récepteur GPS, GLONASS, GNSS1, GNSS2 ;
  - transpondeur ;
  - récepteur DORIS NG ;
  - récepteur DORIS bande étroite.

Les constellations de satellites GPS et GLONASS sont respectivement décrites dans les références [3] et [4].
Le GNSS1 désigne les compléments géostationnaires à GPS et/ou GLONASS utilisant les charges utiles de navigation des satellites INMARSAT 3. Le GNSS2 désigne la future constellation "civile" de satellites de navigation.
DORIS bande étroite désigne un système mondial de radiolocalisation et de radionavigation issu du CNES (Centre National d'Etudes Spatiales). Les signaux transmis par le système sont en bande étroite.
DORIS NG désigne un projet de système mondial de radionavigation et de radiolocalisation spatiale, basé notamment sur l'utilisation de signaux en spectre étalé transmis par des balises au sol, et reçus par des satellites en orbite.

- Le filtre d'orbitographie est un traitement numérique, localisé dans le récepteur, par exemple. Il utilise les mesures brutes faites par ces derniers, c'est-à-dire des mesures de pseudovitesse relatives aux émetteurs de signaux radioélectriques (au sol ou en orbite). Ces mesures peuvent éventuellement être complétées par des mesures de pseudodistances, élaborées à l'aide de la modulation des porteuses reçues. Ces mesures sont traitées pour déterminer de façon autonome les paramètres orbitaux et/ou la position et la vitesse du satellite porteur. La définition de ces mesures est donnée dans la référence [5]. Le filtre peut être des types suivants, cités à titre d'exemple :

  - filtre de Kalman (cf. référence [6]) ;
  - filtre à moindres carrés simples ;
  - filtre à moindres carrés récursifs.

Ce filtre est également capable de déterminer les paramètres suivants :

$V_i = \dot{D}_i =$     Vitesse radiale entre le satellite et l'émetteur n° i.

$\Delta\dot{T}_i =$     Dérive relative entre l'horloge de l'émetteur n° i et l'horloge du récepteur.

Le filtre peut donc estimer les pseudovitesses $PV_i$.

$$PV_i = V_i + C.\ \Delta\dot{T}_i$$

Les grandeurs citées peuvent être estimées même si les signaux provenant de l'émetteur n° i ne sont pas traités par le récepteur et le filtre de navigation associé, pourvu que la position, la vitesse et les coefficients d'horloge dudit émetteur puissent être estimés ou connus par ailleurs.
Le navigateur orbital estime ces pseudovitesses avec la précision $\delta PV$.
Le navigateur orbital peut recevoir des télécommandes de description de manoeuvre du satellite porteur. Ces manoeuvres peuvent être décrites par les paramètres $\Delta Vx(t0)$ ; $\Delta Vy(t0)$ et $\Delta Vz(t0)$, où les $\Delta V_i$ représentent les composantes de l'impulsion en vitesse prévue à la date t0.
Les manoeuvres sont décrites avec une précision notée $\delta Vx$, $\delta Vy$, $\delta Vz$ pour les trois axes. La précision globale de la description de la manoeuvre est $\delta V$, avec :

$$\delta V = \sqrt{\delta V_x^2 + \delta V_y^2 + \delta V_z^2}$$

la technique de réduction de seuil par aide précise en vitesse radiale (ou pseudovitesse radiale) s'applique au cas de récepteurs munis d'une (ou plusieurs) boucle(s) de phase. On suppose que ces boucles sont réalisées en technologie numérique.
Lorsque le signal est reçu avec un rapport C/No inférieur au seuil d'accrochage en mode d'acquisition aidée classique, l'oscillateur commandé numériquement (OCN) de la boucle de porteuse est piloté par une prédiction externe de vitesse (ou pseudovitesse) radiale.
L'accrochage en mode d'acquisition aidée classique est illustré dans les références [1] et [10].

La poursuite de la porteuse en mode de poursuite aidée classique est illustrée dans la référence [9].

Cette prédiction de vitesse doit être fine et provient d'un capteur différent du récepteur. Par exemple, ledit capteur peut être typiquement une centrale inertielle.

Une telle technique peut être également utilisée pour la poursuite des porteuses des signaux GPS à faible rapport C/No équivalent, reçus par des récepteurs GPS interfacés avec des centrales inertielles, fournissant une aide fine de vitesse auxdits récepteurs.

L'invention a pour objet un procédé de réduction autonome des seuils d'acquisition et de poursuite des porteuses reçues en orbite.

Exposé de l'invention

L'invention concerne un procédé de réduction autonome des seuils d'acquisition et de poursuite des porteuses reçues en orbite par un récepteur, à bord d'un satellite, accédant à un navigateur orbital interne ou externe audit récepteur, caractérisé en ce que le récepteur comportant au moins une boucle de phase, caractérisé en ce que cette boucle de phase, chargée de l'accrochage et/ou de la poursuite de la porteuse reçue, est assistée par une aide de vitesse fine délivrée par le navigateur orbital, et rattrape l'erreur entre la vitesse réelle et la vitesse calculée, la recherche de la fréquence Doppler de la porteuse reçue s'effectuant autour d'une prédiction de fréquence entretenue par cette aide de vitesse fine, et en ce que la précision sur l'aide de vitesse fine est telle que :

$$\delta PV < \frac{B}{f_i} \times C$$

où B est la bande d'analyse, C est la vitesse de la lumière et $f_i$ la fréquence du signal porteuse transmis par un émetteur n° i.

Le procédé de l'invention comprend les étapes suivantes :

- le récepteur reçoit les aides nécessaires à l'acquisition aidée, qui permettent au récepteur d'accrocher tous les signaux avec un rapport C/No tel que C/No>(C/No)$_a$, (C/No)$_a$ étant le seuil d'accrochage en mode d'acquisition aidée classique ;
- on réduit les seuils des porteuses jusqu'à la valeur (C/No)$_{avf}$, (C/No)$_{avf}$ étant le seuil d'accrochage des porteuses en mode d'acquisition aidée par une aide fine en vitesse, l'aide de vitesse fine provenant du navigateur orbital.

Ledit procédé peut comporter une étape préliminaire pendant laquelle le récepteur démarre à froid sans aucune aide ou message externe ou interne, et accroche tous les signaux avec un rapport C/No tel que : C/No≥(C/No)$_{na}$ ; (C/No)$_{na}$ étant le seuil d'accrochage en mode non aidé. En ce cas, l'autonomie du récepteur est totale.

En cas de manoeuvre dédiée au contrôle d'orbite du satellite, le navigateur orbital reçoit la description desdites manoeuvres, et met à jour l'aide de vitesse fournie par le navigateur. Pour que l'accrochage des porteuses reçues avec des faibles rapports C/No soit toujours possible en cas de manoeuvre, la- condition suivante doit être respectée, au premier ordre :

$$(\delta PV + \delta V) < \frac{B}{f_i} \times C$$

où $\delta PV$ est l'incertitude sur la prédiction sur la pseudovitesse fournie par le navigateur en absence de manoeuvre, où $\delta V$ est la précision sur la description de la manoeuvre, où B est la bande d'analyse, C la vitesse de la lumière et $f_i$ la fréquence du signal porteuse transmis par l'émetteur n° i.

Lorsqu'une porteuse modulée par des données est poursuivie avec un rapport C/No tel que : (C / No)$_{avf}$ < C / No < (C / No)$_a$, les mises à jour des paramètres caractéristiques des émetteurs peuvent être communiquées au récepteur à l'aide de télécommandes externes si nécessaire, dans le cas où la démodulation desdites données n'est pas possible.

Le procédé de l'invention consiste à réduire les seuils d'acquisition et de poursuite des porteuses par des récepteurs pour satellites munis d'un filtre d'orbitographie embarqué. Cette réduction de seuil est réalisée de façon autonome par lesdits récepteurs utilisant l'invention. Cette réduction de seuil peut être importante.

Brève description des dessins

- La figure 1 illustre un schéma synoptique d'un récepteur à seuil réduit par aide de vitesse fine externe selon l'invention ;
- la figure 2 illustre un schéma synoptique d'un récepteur intégrant le dispositif de l'invention ;
- la figure 3 illustre une variante de l'invention ;
- la figure 4 illustre l'application de l'invention dans le cas d'un récepteur de signaux en spectre étalé.

Exposé détaillé de modes de réalisation

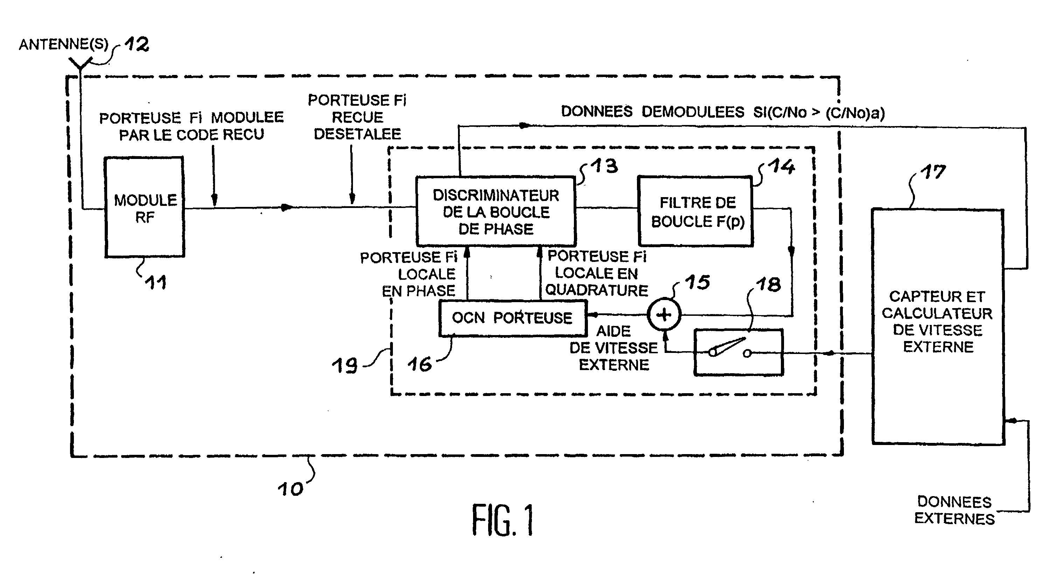

La figure 1 illustre un récepteur en spectre étalé à seuil réduit par aide de vitesse fine externe, seule l'architecture de base du traitement numérique étant représentée.

Ce récepteur 10 comprend au moins un module RF 11 relié à au moins une antenne 12 dont le signal de sortie est relié à un discriminateur 13 de la boucle de phase suivi d'un filtre de boucle 14, et d'un sommateur 15. Un module OCN (oscillateur commandé numériquement) porteuse 16 transmet une porteuse locale $F_i$ en phase (et en quadrature dans certains cas) au discriminateur 13, et est relié à la sortie du sommateur 15. Le discriminateur 13 peut intégrer un filtre de prédétection. Le commutateur 15 reçoit également un signal en provenance d'un ensemble capteur et calculateur de vitesse externe 17 (centrale inertielle par exemple), à travers un commutateur 18. Le commutateur 18 est refermé lorsque la boucle de porteuse 19 nécessite l'aide de vitesse fine externe pour l'accrochage et/ou la poursuite des porteuses reçues.

*Poursuite*

La boucle de phase, chargée de la poursuite des porteuses, est "poussée" par l'aide de vitesse. En d'autres termes, l'oscillateur OCN de cette boucle fait varier la phase de la porteuse locale avec une vitesse égale à l'aide de la prédiction externe de vitesse. La boucle de phase ainsi "poussée" rattrape l'erreur entre la vitesse réelle et la vitesse calculée.

L'ordre de cette boucle doit être suffisant pour maintenir l'oscillateur OCN asservi, ce qui permet de produire des mesures de pseudovitesse, à l'aide d'un compteur Doppler.

*Acquisition*

La boucle de phase, chargée de l'acquisition des porteuses, est également "poussée" par l'aide de vitesse fine. La recherche de la fréquence Doppler de la porteuse reçue s'effectue autour d'une prédiction de fréquence (prépositionnement Doppler fin) entretenue par l'aide de vitesse externe.

La zone de recherche de la fréquence de la porteuse reçue est plus petite que dans le cas d'une acquisition en mode aidé classique. En effet, le principe décrit fonctionne si l'incertitude de la prédiction Doppler $\Delta F_D$ est inférieure à une bande d'analyse B.

L'incertitude $\delta PV$ sur la prédiction de pseudovitesse doit donc respecter les relations suivantes :

$$\Delta F_D < B \qquad \text{soit : } \delta PV < \frac{B}{f_i} \times C$$

où C est la vitesse de la lumière et $f_i$ la fréquence du signal porteuse transmis par l'émetteur n° i.

Ainsi, les zones d'incertitude en Doppler étant plus faibles que dans les cas classiques, la recherche d'énergie peut s'effectuer avec une vitesse de balayage de la porteuse locale beaucoup plus lente que dans ces cas classiques, pour une même durée de recherche notée T. Le seuil d'acquisition s'en trouve ainsi réduit.

On définit les rapports C/No suivants :

$(C/No)_{na} =$     Seuil d'accrochage en mode aidé.

$(C/No)_a =$     Seuil d'accrochage en mode d'acquisition aidée classique

$(C/No)_{avf} =$     Seuil d'accrochage des porteuses en mode d'acquisition aidée par une aide fine de vitesse

La définition des seuils $(C/No)_{na}$ et $(C/No)_a$ est détaillée en référence [1].

Le seuil $(C/No)_{avf}$ est une fonction de plusieurs paramètres.

$$(C/No)_{avf} = g(T;\delta PV;B)$$

L'invention se caractérise par le procédé suivant, mis en oeuvre dans un récepteur en spectre étalé pour satellite, muni d'un navigateur orbital.

*Etape 1 (facultative)*

Le récepteur démarre à froid (sans aucune aide ou message externe ou interne). Il accroche tous les signaux avec un rapport C/No tel que :

$$C/No \geq (C/No)_{na}$$

Les premiers signaux accrochés peuvent éventuellement permettre au récepteur de :

- recevoir des messages permettant de déterminer la position et/ou la vitesse et/ou les coefficients d'horloge des émetteurs n° i ;
- faire converger le navigateur orbital, à l'aide des premières mesures de pseudovitesse réalisées et des datations associées.

Cette première étape est nécessaire pour les missions spatiales entièrement autonomes.

*Etape 2*

Le récepteur reçoit des aides nécessaires à l'acquisition aidée classique. Ces aides sont peu précises (grossières) et du type :

1) Date et temps de l'horloge du récepteur.
2) Positions/vitesses (ou, éventuellement, paramètres orbitaux) des émetteurs.
3) Position/vitesse ou paramètres orbitaux du satellite porteur.

Ces aides peuvent provenir en partie ou totalement de l'étape 1. Dans ce cas, elles sont internes au récepteur (par exemple : les positions/vitesses des émetteurs peuvent être transmises par lesdits émetteurs). La fonction d'autonomie est conservée.

Dans le cas où tout ou partie de ces aides grossières est communiqué au récepteur par le biais de télécommandes externes, celui-ci n'est plus entièrement autonome.

Dans le cas où l'étape 1 n'est pas réalisée, ces aides sont obligatoirement externes au récepteur.

Ces aides grossières permettent au récepteur d'accrocher tous les signaux avec un rapport C/No tel que :

$$C/No > (C/No)_a$$

Le nombre de mesures de pseudovitesse augmente alors, par rapport au cas de l'étape 1, car :

$$(C/No)_a < (C/No)_{na}.$$

Le nombre de ces mesures est supposé suffisant pour faire converger le navigateur orbital fournissant les paramètres orbitaux du satellite porteur avec une précision meilleure que dans l'étape 1.

### Etape 3

L'étape 2 étant réalisée, on suppose que la précision des paramètres de sortie du navigateur orbital et des paramètres caractéristiques des émetteurs est compatible avec la finesse de l'aide de vitesse requise pour réduire encore les seuils d'accrochage des porteuses, jusqu'à la valeur $(C/No)_{avf}$.

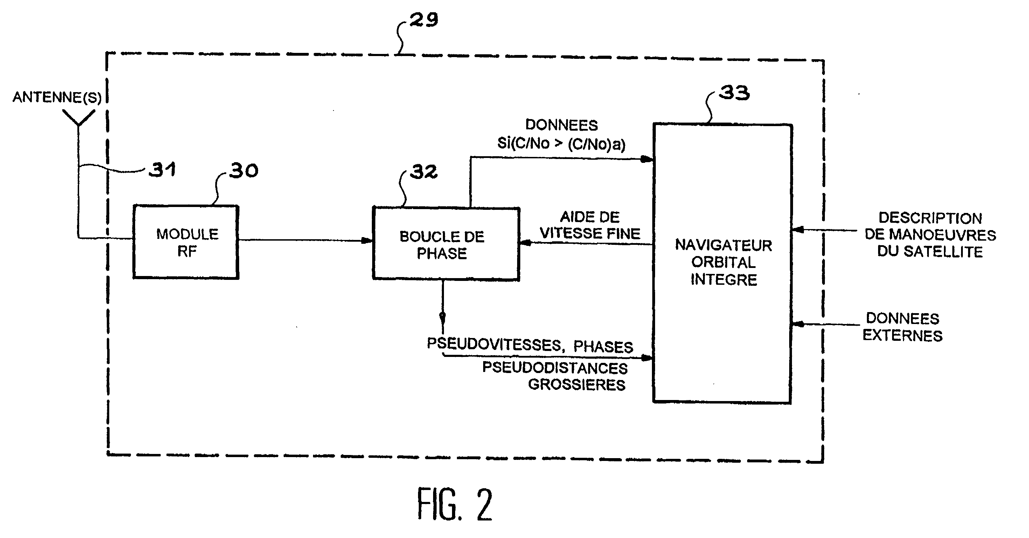

Contrairement à l'état de l'art connu, l'aide fine de vitesse provient du navigateur orbital intégré au récepteur. Cette aide est donc interne et l'autonomie est conservée, comme représenté sur la figure 2.

La précision du navigateur peut donc être encore améliorée. Par ailleurs, en cas de dégradation progressive du bilan de liaison avec les émetteurs, la dégradation de cette précision peut être limitée.

On a donc :

$$(C/No)_{avf} < (C/No)_a$$

### Etape 4

En cas de manoeuvre dédiée au contrôle d'orbite du satellite, le navigateur orbital reçoit la description desdites manoeuvres, et met à jour l'aide de vitesse fournie par le navigateur.

Pour que l'accrochage des codes pseudoaléatoires reçus avec des faibles rapports C/No soit toujours possible en cas de manoeuvres, la condition suivante doit être respectée au premier ordre :

$$(\delta PV + \delta V) < \frac{B}{f_i} \times C$$

où $\delta PV$ est la prédiction sur la pseudovitesse fournie par le navigateur en absence de manoeuvre, et $\delta V$ est la précision sur la description de la manoeuvre.

### Etape 5

Lorsqu'un code pseudoaléatoire est poursuivi avec un rapport C/No tel que :

$$(C/No)_{avf} < C/No < (C/No)_a$$

la démodulation des données du message transmis par les émetteurs n'est pas toujours possible.

Dans ce dernier cas, les mises à jour des paramètres caractéristiques des émetteurs (positions et/ou vitesses et/ou coefficients d'horloge) doivent donc être communiquées au récepteur à l'aide de télécommandes externes, si nécessaire. Par exemple, dans le cas d'un récepteur GPS ou GLONASS, ces paramètres peuvent être les éphémérides de la constellation utilisée.

La figure 2 illustre un récepteur 29 de signaux radioélectriques pour satellites qui comprend au moins un module RF 30, recevant un signal en provenance d'au moins une antenne 31, relié à au moins une boucle de phase 32. Un navigateur orbital intégré 33 reçoit de la boucle de phase les données si $(C/No) > (C/No)_a$. Ce navigateur envoie à la boucle de phase une aide de vitesse fine.

Le navigateur orbital intégré reçoit la description de manoeuvres du satellite et les données externes.

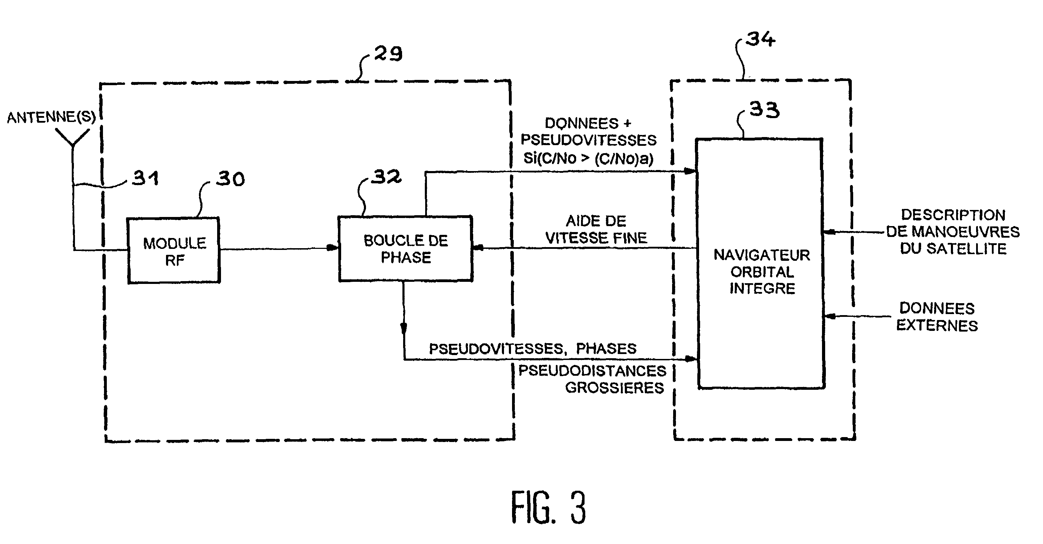

La figure 3 illustre une variante de l'invention, où le navigateur orbital est intégré dans un calculateur de bord 34 présent dans le satellite.

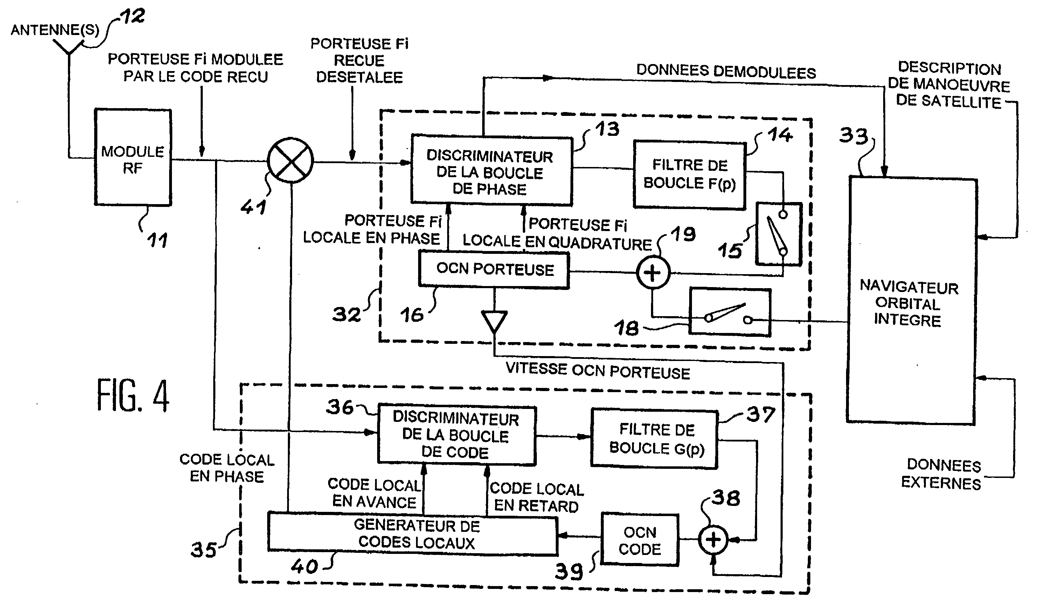

La figure 4 illustre un exemple de l'invention, où le récepteur 29 peut traiter des signaux en spectre étalé.

Le récepteur 29 comprend au moins une boucle de phase 32 et au moins une boucle de code 35. La boucle de phase 32 comprend un commutateur 19, placé entre le filtre de boucle F(p) 14 et le sommateur 15.

La boucle de code comprend un discriminateur 36, recevant les porteuses modulées par les codes pseudoaléatoires reçus, provenant d'un module RF 11. Ce discriminateur peut intégrer un filtre de prédétection. La sortie de ce discriminateur est reliée à un filtre de boucle G(P) 37. Un sommateur 38 reçoit la sortie du filtre 37 et le signal vitesse OCN porteuse fourni par l'OCN porteuse 16. La sortie de ce sommateur est connectée à un OCN code 39, lui-même relié à un générateur de codes locaux 40.

Ce générateur 40 est relié d'une part à un corrélateur 41 et lui délivre le code local en phase, et d'autre part au discriminateur 36, et lui délivre le code local en avance et le code local en retard. Le discriminateur 13 de la boucle de phase est relié au corrélateur 41.

La boucle de code 35 reçoit une aide de vitesse fine issue du NCO porteuse 16. Le commutateur 18 est fermé si la boucle de porteuse nécessite une aide de vitesse fine provenant du navigateur orbital intégré 33, pour fonctionner en mode d'accrochage et/ou de poursuite de la porteuse.

Le commutateur 18 reste fermé si C/No < (C/No)avf. Dans ce cas, la boucle de porteuse ne peut ni acquérir ni poursuivre la porteuse, et le commutateur 19 est ouvert. La boucle de porteuse fournit donc directement l'aide de vitesse fine provenant du navigateur 33 à la boucle de code 35.

Exemples d'application

Les applications du procédé de l'invention concernant la réception de porteuses à bord de satellites concernent les cas défavorables de bilans de liaison entre les émetteurs utilisés et lesdits satellites.

Par exemple ces applications peuvent être :

*du point de vue des types de récepteurs*

* Navigation à l'aide d'un récepteur de constellation de satellites (comme GPS, GLONASS).
* Navigation à l'aide d'un transpondeur en spectre étalé. Le bilan de liaison peut être défavorable en début et en fin de survol d'une station de télécommande/télémesure (TM/TC), ou en début et en fin de passage d'un satellite relais tel que TDRSS.
* Navigation à l'aide d'un récepteur DORIS bande étroite.
* Navigation à l'aide d'un récepteur de signaux en spectre étalé transmis par un parc de balises au sol, munies d'antenne à diagramme de type hémisphérique. La puissance transmise par ces balises est supposée optimisée pour une utilisation par des satellites en orbite basse. Le bilan de liaison est donc supposé moins favorable pour un satellite en orbite géostationnaire, par exemple.
* Détection d'attitude à l'aide d'un récepteur de constellation de satellites (comme GPS, GLONASS) ou de signaux en spectre étalé transmis par un parc de balises au sol (comme DORIS NG). Le nombre de mesures interférométriques obenues à l'aide des porteuses reçues pour C/No ≥ (C/No)a n'est pas nécessairement suffisant pour les applications de détection de l'attitude. L'acquisition et/ou la poursuite des porteuses reçues pour C/No ≥ (C/No)avf peut être nécessaire dans certains cas.

*du point de vue des orbites*

* Navigation à l'aide d'un récepteur GPS, ou DORIS NG pour certaines orbites de transfert géostationnaire. Ces orbites de transfert géostationnaire peuvent être des types suivants :

  - orbite de transfert géostationnaire classique (OTG) ;
  - orbite supersynchrone (OSPS) ;
  - orbite sub-synchrone (OSBS) ;
  - orbite de dérive (ODD) ;

Ces navigations peuvent être réalisées avec au moins deux antennes à faible gain, si le seuil d'accrochage des signaux est faible (cf. référence [7]).

* Navigation à l'aide d'un récepteur en orbite à haut apogée pouvant être des types suivants cités à titre d'exemple (cf. référence [8]) :

  - orbite Molniya ;
  - orbite Tundra ;
  - orbite Archimède.

* Navigation à l'aide d'un récepteur en orbite circulaire pour constellation de satellites de navigation, de période de l'ordre de douze heures. La réception de balises au sol à antenne hémisphérique est adaptée à ce cas de figure.

* Navigation à l'aide d'un récepteur en orbite basse, connecté à une ou plusieurs antennes de réception à faible coût, et donc non optimisées, mais suffisamment bonnes pour permettre au récepteur de réaliser l'étape 2 décrite dans l'invention.

REFERENCES

[1] "Orbital Navigation With a GPS Receiver On The HETE Spacecraft" (ION GPS janvier 94, pages 645-656)

[2] "ESA Dual-Standard S-Band Transponder : A Versatile TT&C Equipment For Communications Via A Data Relay Satellite Or Directly With The Ground Network" de J.L. Gerner (42nd Congress Of The International Astronautical Federation,5-11 octobre 1991)

[3] "Accord de standardisation ; caractéristiques du système mondial de détermination de la position NAVSTAR (GPS)" (OTAN, STANAG 4294)

[4] "GLONASS Approaches Full Operational Capability (FOC)" de P. Daly ( ION GPS, septembre 1995)

[5] "Techniques et technologies des véhicules spatiaux module 6. Localisation spatiale" (Editions Cépaduès)

[6] "Low-Orbit Navigation Concepts" de H.James Rome (vol. 35, n° 3, Fall 1988, pages 371-390)

[7] "GPS Techniques For Navigation Of Geostationary Satellites" de P. Ferrage, J.L. Issler, G. Campan et J.C. Durand (ION GPS, 12-15 septembre 1995)

[8] "Applicability Of GPS-Based Orbit Determination Systems To A Wide Range of HEO Missions" de J. Potti, P. Bernedo et A. Pasetti (ION GPS, 12-15 septembre 1995)

[9] EP-A-0 274 958

[10] EP-A-0 544 358

## Revendications

**1.** Procédé de réduction autonome des seuils d'acquisition et de poursuite des porteuses reçues en orbite par un récepteur, à bord d'un satellite, accédant à un navigateur orbital interne ou externe audit récepteur, le récepteur comportant au moins une boucle de phase, **caractérisé en ce que** cette boucle de phase, chargée de l'accrochage et/ou de la poursuite de la porteuse reçue, est assistée par une aide de vitesse fine délivrée par le navigateur orbital, et rattrape l'erreur entre la vitesse réelle et la vitesse calculée, la recherche de la fréquence Doppler de la porteuse reçue s'effectuant autour d'une prédiction de fréquence entretenue par cette aide de vitesse fine, et **en ce que** la précision sur l'aide de vitesse fine est telle que :

$$\delta PV < \frac{B}{f_i} \times C$$

où B est la bande d'analyse, C est la vitesse de la lumière et $f_i$ la fréquence du signal porteuse transmis par un émetteur n° i.

**2.** Procédé selon la revendication 1, **caractérisé en ce qu'**il comprend les étapes suivantes :

- le récepteur reçoit les aides nécessaires à l'acquisition aidée, qui permettent au récepteur d'accrocher tous les signaux avec un rapport C/No tel que C/No>(C/No)$_a$, (C/No)$_a$ étant le seuil d'accrochage en mode d'acquisition aidée classique ;

- on réduit les seuils des porteuses jusqu'à la valeur (C/No)$_{avf}$, (C/No)$_{avf}$ étant le seuil d'accrochage des porteuses en mode d'acquisition aidée par une aide fine en vitesse, l'aide de vitesse fine provenant du navigateur orbital.

**3.** Procédé selon la revendication 2, **caractérisé en ce qu'**en cas de manoeuvre dédiée au contrôle d'orbite du satellite, le navigateur orbital reçoit la description desdites manoeuvres, et met à jour l'aide de vitesse fournie par le navigateur, et **en ce que** la condition suivante est respectée :

$$(\delta PV + \delta V) < \frac{B}{f_i} \times C$$

où $\delta PV$ est l'incertitude sur la prédiction sur la pseudovitesse fournie par le navigateur, en absence de manoeuvre ; où $\delta V$ est la précision sur la description de la manoeuvre ; où B est la bande d'analyse, C la vitesse de la lumière et fi la fréquence du signal porteuse transmis par l'émetteur n° i.

**4.** Procédé selon la revendication 2, **caractérisé en ce que** lorsqu'une porteuse modulée par des données est poursuivie avec un rapport C/No tel que : (C/No)$_{avf}$<C/No<(C/No)$_a$, les mises à jour des paramètres caractéristiques des émetteurs peuvent être communiquées au récepteur à l'aide de télécommandes externes, dans le cas où la démodulation desdites données n'est pas possible.

## Patentansprüche

**1.** Verfahren zur autonomen Reduzierung der Schwellenwerte zur Erfassung und Verfolgung der in der Umlaufbahn durch einen Empfänger an Bord eines Satelliten empfangenen Träger, der den Zugang zu einem bezüglich dieses Empfängers internen oder externen Orbitalnavigator bildet, wobei der Empfänger wenigstens eine Phasenschleife umfasst, **dadurch gekennzeichnet,**
**dass** diese Phasenschleife, deren Aufgabe das Auffangen und/oder Verfolgen des empfangenen Trägers ist, unterstützt wird durch eine Feingeschwindigkeitshilfe, geliefert durch den Orbitalnavigator, und den Fehler zwischen der wirklichen Geschwindigkeit und der berechneten Geschwindigkeit beseitigt bzw. wiedergutmacht, wobei die Suche der Doppler-Frequenz des empfangenen Trägers um eine Frequenzvoraussage herum erfolgt, die unterhalten wird durch diese Feingeschwindigkeitshilfe, und dadurch, dass die Genauigkeit bezüglich der Feingeschwindigkeitshilfe so ist, dass:

$$\delta PV < \frac{B}{f_i} x\ C$$

wo B das Analyseband ist, C die Lichtgeschwindigkeit ist, und $f_i$ die Frequenz des Trägersignals ist, übertragen durch einen Sender Nr. i.

2. Verfahren nach Anspruch 1, **dadurch gekennzeichnet, dass** es die folgenden Schritte umfasst:

- der Empfänger erhält die für die unterstützte Erfassung nötigen Hilfen, die dem Empfänger ermöglichen, alle Signale aufzufangen, deren C/No-Verhältnis so ist, dass C/No>(C/No)$_a$, wobei (C/No)$_a$ der Auffangschwellenwert im klassisch unterstützten Erfassungsbetrieb ist,
- man reduziert die Schwellenwerte der Träger bis auf einen Wert (C/No)$_{avf}$, wobei (C/No)$_{avf}$ der Auffangschwellenwert der Träger im Erfassungsbetrieb ist, der unterstützt wird durch eine Feingeschwindigkeitshilfe, die vom Orbitalnavigator geliefert wird.

3. Verfahren nach Anspruch 2, **dadurch gekennzeichnet, dass** im Falle eines zur Kontrolle der Umlaufbahn des Satelliten durchgeführten Manövers der Orbitalnavigator die Beschreibung der genannten Manöver erhält und die durch den Navigator gelieferte Geschwindigkeit aktualisiert, und dadurch, dass die folgende Bedingung eingehalten wird:

$$(\delta PV + \delta V) < \frac{B}{f_i} x\ C$$

wo $\delta PV$ die Ungewissheit bezüglich der durch den Navigator gelieferten Vorrausage über die Pseudogeschwindigkeit ist, ohne Manöver; wo $\delta V$ die Genauigkeit bezüglich der Beschreibung des Manövers ist; wo B das Analyseband ist, C die Lichtgeschwindigkeit ist und fi die Frequenz des durch den Sender Nr. i übertragenen Trägersignals ist.

4. Verfahren nach Anspruch 2, **dadurch gekennzeichnet, dass** bei der Verfolgung eines durch Daten modulierten Trägers mit einem C/No-Verhältnis, das so ist, dass (C/No)$_{avf}$<C/No<(C/No)$_a$, falls die Demodulation der genannten Daten nicht möglich ist, die Aktualisierungen der charakteristischen Parameter der Sender dem Empfänger mittels externer Fernsteuerungen mitgeteilt werden können.

## Claims

1. Process for the autonomous reduction of acquisition and tracking thresholds of carriers received in orbit by a receiver accessing an integrated orbital navigator inside or outside said receiver, **characterized by** the threshold reduction procedure by precise radial speed aid (or pseudospeed), the receiver having at least one phase loop, which is responsible for the acquisition and/or tracking of the carrier, is assisted by a fine speed aid delivered by the orbit navigator and takes up the error between the real speed and the calculated speed, the search of the Doppler frequency of the received carrier taking place about a frequency prediction maintained by said fine speed aid and in that the precision of the fine speed aid is such that:

$$\delta PV < \frac{B}{fi} x\ C,$$

where B is the analysis band, C the speed of light and fi the frequency of the carrier signal transmitted by emitter i.

2. Process according to claim 1, **characterized in that** it comprises the stages of the receiver receiving the aids necessary for conventional aided acquisition, which enable the receiver to lock on all the signals with a ratio C/No such that C/No > (C/No)$_a$, (C/No)$_a$ being the locking threshold in the conventional aided acquisition mode and reduction takes place of the thresholds of the carriers to the value (C/No)$_{avf}$, (C/No)$_{avf}$ being the locking threshold of the carriers in the acquisition mode aided by a fine speed aid, the latter coming from the orbital navigator.

3. Process according to claim 2, **characterized in that** in the case of a manoeuvre dedicated to the orbital control of the satellite, the orbital navigator receives the description of said manoeuvres and updates the speed aid supplied by the navigator, and **in that** the following condition is respected:

$$(\delta PV + \delta V) \frac{B}{fi} x\ C$$

in which $\delta PV$ is the uncertainty on the prediction on the pseudospeed supplied by the navigator, in the absence of a manoeuvre, $\delta V$ is the precision on the description of the manoeuvre, B is the analysis band, C the speed of light and fi the frequency of the carrier signal transmitted by the emitter i.

4. Process according to claim 2, **characterized in that** when a data-modulated carrier is tracked with a ratio C/No such that (C/No)$_{avf}$ C/No (C/No)$_a$, the

updatings of the characteristic parameters of the emitters can be communicated to the receiver with the aid of external remote controls, in the case where the demodulation of said data is impossible.

FIG. 1

ANTENNE(S) **12**

PORTEUSE Fi MODULEE PAR LE CODE RECU

PORTEUSE Fi RECUE DESETALEE

DONNEES DEMODULEES SI(C/No > (C/No)a)

MODULE RF **11**

DISCRIMINATEUR DE LA BOUCLE DE PHASE **13**

FILTRE DE BOUCLE F(p) **14**

CAPTEUR ET CALCULATEUR DE VITESSE EXTERNE **17**

PORTEUSE Fi LOCALE EN PHASE

PORTEUSE Fi LOCALE EN QUADRATURE

**15**

**18**

OCN PORTEUSE

AIDE DE VITESSE EXTERNE

**19** **16**

**10**

DONNEES EXTERNES

EP 0 824 706 B1

FIG. 2

EP 0 824 706 B1

FIG. 3

ANTENNE(S) _12_

PORTEUSE Fi MODULEE
PAR LE CODE RECU

PORTEUSE Fi
RECUE
DESETALEE

DONNEES DEMODULEES

DESCRIPTION
DE MANOEUVRE
DE SATELLITE

MODULE
RF

_11_

_41_

DISCRIMINATEUR
DE LA BOUCLE
DE PHASE _13_

FILTRE DE
BOUCLE F(p) _14_

_33_

PORTEUSE Fi
LOCALE EN PHASE

PORTEUSE Fi
LOCALE EN QUADRATURE _19_

_15_

OCN PORTEUSE

_32_      _16_

_18_

NAVIGATEUR
ORBITAL
INTEGRE

VITESSE OCN PORTEUSE

FIG. 4

_36_

DISCRIMINATEUR
DE LA BOUCLE
DE CODE

FILTRE DE
BOUCLE G(p) _37_

CODE LOCAL
EN PHASE

CODE LOCAL
EN AVANCE

CODE LOCAL
EN RETARD

_38_

_35_

GENERATEUR DE
CODES LOCAUX

OCN
CODE

DONNEES
EXTERNES

_40_

_39_

EP 0 824 706 B1

13